Europäisches Patentamt

European Patent Office

Office européen des brevets

(11) Publication number: **0 349 301**
**A2**

# EUROPEAN PATENT APPLICATION

(21) Application number: **89306581.3**

(22) Date of filing: **28.06.89**

(51) Int. Cl.⁵: **G 03 F 7/004**
**G 03 F 7/022**

(30) Priority: **28.06.88 JP 160439/88**
**17.05.89 JP 123967/89**

(43) Date of publication of application:
**03.01.90 Bulletin 90/01**

(84) Designated Contracting States: **DE NL**

(71) Applicant: **MITSUBISHI KASEI CORPORATION**
**5-2, Marunouchi 2-chome Chiyoda-ku**
**Tokyo 100 (JP)**

(72) Inventor: **Nishi, Mineo**
**1-2-72-601 Aoyama Yahatanishi-ku**
**Kitakyushu-shi Fukuoka-ken (JP)**

**Sakaguchi, Masahiro**
**1-6-315-42 Sainokami Yahatanishi-ku**
**Kitakyushu-shi Fukuoka-ken (JP)**

**Miyazaki, Akio**
**1957-3 Kotake Wakamatsu-ku**
**Kitakyushu-shi Fukuoka-ken (JP)**

(74) Representative: **Woods, Geoffrey Corlett et al**
**J.A. KEMP & CO. 14 South Square Gray's Inn**
**London WC1R 5EU (GB)**

(54) **Positive-type photoresist composition.**

(57) A positive-type photoresist composition comprising an alkali-soluble resin, a sensitizer having an orthoquinone-diazido group and a solvent, which solvent comprises a diester of glycol, having not more than 10 carbon atoms in total, of formula (I):

$$R^1COOCHR^2(CH_2)_nCHR^3OOCR^4 \qquad (I)$$

wherein $R^1$, $R^2$, $R^3$ and $R^4$, which may be identical or different, each represents a hydrogen atom, a methyl group or an ethyl group, and n is 0, 1 or 2.

**Description**

## POSITIVE-TYPE PHOTORESIST COMPOSITION

The present invention relates to a positive-type photoresist composition which is generally reactive to radiant rays, and, more particularly, to a positive-type photoresist composition comprising an alkali-soluble resin, a sensitizer having orthoquinonediazido group and a solvent.

Integrated circuits have been increasingly highly integrated year by year. For example, in a dynamic random access memory (hereinunder referred to as "DRAM"), an integrated circuit having a memory capacity of 1M bit has been put to industrial-scale production. In accordance with such a trend, requirements for the improvement of photolithography technique which is essential for the production of integrated circuits, has become increasingly severe. For example, lithography technique at a 1 μm-level is required for the production of a 1M bit DRAM, and lithography techniques at 0.8 μm-level and 0.5 μm-level will be required for 4M and 16M DRAMS which are expected to be produced one year after and five years after, respectively.

In such photolithography technique, a positive-type photoresist is mainly used at present, and various high-efficiency positive type photoresists have been proposed to attain the above-described required levels [See, e.g., Japanese Patent Application Laid-Open Nos. 61-118744 (1986) and 61-185741 (1987)].

A positive-type photoresist is generally provided in the form of a coating composition obtained by dissolving an alkali-soluble resin and a sensitizer having an orthoquinonediazido group in an appropriate solvent. The coating composition is generally applied to a silicon wafer by spin coating.

In order to obtain a good coating film by spin coating, it is necessary that the coating solvent evaporates at an appropriate rate. The solvents which are capable of dissolving a sensitizer having an orthoquinonediazido group are limited. The kinds of the solvents which can be selected for the preparation of a positive-type photoresist composition are therefore very few. The solvents mainly used at present are ethylene glycol methyl ether acetate and ethylene glycol ethyl ether acetate.

Although these solvents are excellent in solubility and coating property, the toxicity thereof to the human body has recently been recognized. Accordingly, in response to a demand for development of a solvent having a lower toxicity which replaces the above-described solvents, solvents such as cyclic ketone solvents and propylene glycol alkyl ether acetate solvents are have been proposed [See, e.g., Japanese Patent Application Laid-Open Nos. 59-155838 (1984), 59-231534 (1984), 61-6648 (1986) and 61-7837 (1986), and KAGAKU KEIZAI, Aug. 1988, pp. 72 to 77].

As a premise for satisfying the desired resolution of a photoresist, it is necessary to limit the content of foreign substances contained therein such as dust to the minimum. As such foreign susbtances, there are not only dust which is easy to remove after precise filtration but also insoluble substances generating in the photoresist after precision filtration. Such insoluble substances have become a problem.

A high-efficiency positive-type photoresist recently proposed is more likely to produce such insoluble substances than a conventional one, and the amelioration of the defect has been demanded.

As a result of various studies undertaken to resolve the above-described problems in the prior art and to provide a positive-type photoresist composition having a good preservation stability by using a solvent having a low toxicity, and excellent solubility and coating property to suppress the generation of insoluble foreign substances, it has been found that a positive-type photoresist composition using a specific diester of glycol as a solvent is excellent in solubility, coating property and preservation stability. The present invention has been achieved on the basis of this finding.

In an aspect of the present invention, there is provided a positive-type photoresist composition comprising an alkali-soluble resin, a sensitizer having orthoquinonediazido group and a solvent containing a diester of glycol having not more than 10 carbon atoms in total represented by the following general formula (I):

$R^1COOCHR^2(CH_2)_nCHR^3COOCR^4$  (I)

wherein $R^1$, $R^2$, $R^3$ and $R^4$ each represent a hydrogen atom, a methyl group or an ethyl group and may be either the same or different from each other, and n is 0, 1 or 2.

The carboxylic acid group in the general formula (I) is not restricted so long as the above-described conditions are satisfied, but an acetic acid group is preferable because it is easily available. If a diester of glycol has more than 10 carbon atoms in total, the boiling point thereof is so high that the solvent is difficult to evaporate during spin coating and a viscosity of the photoresist composition does not become higher, and as a result various disadvantages are caused. For example, the thickness of the coating film becomes too thin, the solvent remains in the coating film, thereby deteriorating the heat-resistance, or the solubility of the sensitizer lowers, thereby deteriorating the preservation stability.

In the present invention, as a diester of glycol having not more than 10 carbon atoms in total, represented by the general formula (I), ethylene glycol diformate, ethylene glycol diacetate, ethylene glycol dipropionate, propylene glycol diacetate, propylene glycol dipropionate, butanediol diacetate, butanediol dipropionate and the like are usable. Asymmetric diesters are also usable. Among these, ethylene glycol diacetate and propylene glycol diacetate are particularly preferable.

A diester of glycol having not more than 10 carbon atoms in total, represented by the general formula (I) may be used either singly or in the form of a mixture unless impairing the effect thereof.

Also, when such a diester of glycol is used in the form of a mixture with a low-boiling organic solvent having a boiling point of 50 to 140° C, the thickness of the coating film is favorably controllable. Organic solvents having a boiling point of 50 to 140°C may be used either singly or in the form of a mixture.

An organic solvent having a boiling point of 50 to 140°C is selected from ketones, carboxylates, carbonates, alcohols and ethers. Especially, acetone, methyl ethyl ketone, diethyl ketone, methyl isobutyl ketone, ethyl acetate, propyl acetate, butyl acetate, dimethyl carbonate, diethyl carbonate, methanol, ethanol, propanol,butanol, methoxy propanol, ethoxy propanol, tetrahydrofuran, dioxane, propylene glycol monomethyl ether and the like are preferable from the point of view of solubility with respect to an alkali-soluble resin and a sensitizer.

The mixing ratio of the diester of glycol having not more than 10 carbon atoms, represented by the general formula (I) and an organic solvent having a boiling point of 50 to 140°C is not limited, but the diester of glycol having not more than 10 carbon atoms, represented by the general formula (I) is 60 to 99 wt%, preferably 80 to 99 wt%, and an organic solvent having a boiling point of 50 to 140°C is 40 to 1 wt%, preferably 20 to 1 wt%. If the content of an organic solvent having a boiling point of 50 to 140°C is more than 40 wt%, the evaporating ratio unfavorably becomes too high and the film thickness unfavorably becomes too thick.

As examples of an alkali-soluble resin used in the present invention, a novolak resin, polyhydroxystyrene and a derivative thereof, and a styrene-maleic anhydride copolymer may be exemplified. Among these, a novolak resin is preferable. More preferably, a novolak resin obtained by condensing a phenol ingredient such as phenol, cresol, xylenol, ethyl phenol, catechol and resorcinol used singly or in the form of a mixture with an aldehyde ingredient such as formaldehyde, paraformaldehyde, acetaldehyde and benzaldehyde is used.

As a sensitizer, an ester or an amide of 1,2-naphthoquinonediazido-5-sulfonic acid, 1,2-naphthoquinonediazido4-sulfonic acid, 1,2-benzoquinonediazido-4-sulfonic acid or the like is used. A 1,2-naphthoquinonediazido-5-sulfonate or 1,2-naphthoquinonediazido-4-sulfonate of a polyhydroxy aromatic compound is preferably used. More preferably, the 1,2-naphthoquinonediazido-5-sulfonate or the 1,2-naphthoquinonediazido-4-sulfonate of a polyhydroxybenzophenone such as 2,3,4-trihydroxybenzophenone, 2,3,4,4'-tetrahydroxybenzophenone, 2,2',4,4'-tetrahydroxybenzophenone or 2,3,4,2',4'-pentahydroxybenzophenone is used.

The mixing ratio of an alkali-soluble resin to a sensitizer is generally 100 wt% : 5 to 100 wt%, preferably 100 wt% : 10 to 80 wt%.

The amount of solvent used is not limited, but the amount is preferably determined so that the total concentration of the alkali-soluble resin and the sensitizer is 3 to 50 wt%.

A surfactant or the like for ameliorating a coating defect such as striation may be added, if necessary.

A photoresist composition according to the present invention is useful for the production of not only ultra LSIs but also general LSIs and masks.

A photoresist composition according to the present invention has a low toxicity, and good coating property and preservation stability, so that it is usable for the production of ultra LSIs, general ICs and masks. Thus, the present invention is industrially useful.

The present invention will be explained in more detail with reference to the following examples, but it is to be understood that the present invention is not restricted by those examples within the scope of the invention.

Examples 1 to 7 and Comparative Examples 1 to 4

A mixture of m-cresol, p-cresol, 2,5-xylenol (3 : 4 : 3 by a molar ratio) was condensed with formaldehyde to obtain a novolak resin, and 2,3,4,4'-tetrahydroxybenzophenone was esterified by 1,2-naphthoquinonediazido-5-sulfonic acid. 3 g of the thus obtained novolak resin and 1 g of the thus obtained ester were dissolved in each of 10 g of the solvents shown in Table 1 and the solubility was observed. A coating property modifier (Florard FC-430 : trade name, produced by Sumitomo 3M Co. Ltd.) was added to the solution in a ratio of 100 ppm, and the solution was precisely filtered out through 0.2 μm Teflon filter paper to prepare a photoresist composition.

A silicon wafer 5 inch in diameter was coated with the thus obtained photoresist composition by using a spin coater (SCW 636, produced by Dainippon Screen Mfg. Co., Ltd.) and prebaked on a hot plate at 110°C for 90 seconds. Thereafter, the coating property of each of the thus coated silicon wafer (whether striation was produced or not) was observed. The results are shown in Table 1.

Separately from this experiment, each of the photoresist compositions was heated to and kept at 45°C and the time elapsed until insoluble foreign substances produced was measured as a heat-accelerating test for the preservation stability. In order to judge the generation of insoluble foreign matters, a silicon wafer was coated with the thus heat-treated photoresist composition in the same way as above, and the number of the foreign substances in the photoresist coating film was counted by a laser surface inspection machine (LS-5000, produced by Hitachi Electronics Engineering, Ltd.). The time elapsed until not less than 100 foreign substances not less than 0.3 μm in size were generated, was measured. In each of the photoresist compositions before heating, the number of the foreign substances of not less than 0.3 μm in size was less than 20. The results are shown in Table 1.

Example 8

A photoresist composition was prepared and tested in the same way as in Example 1 except for using a mixture of m-cresol and p-cresol (6 : 4 by a molar ratio) in place of m-cresol, p-cresol, 2,5-xylenol (3 : 4 : 3 by a molar ratio). The results are shown in Table 1.

Example 9

A photoresist composition was prepared and tested in the same way as in Example 3 except for using 2,2',3,4,4'-pentadehydroxybenzophenone in place of 2,3,4,4'-tetrahydroxybenzophenone. The results are shown in Table 1.

**Comparative Example 5**

A photoresist composition was prepared in the same way as in Example 1 except for using ethylene glycol diisovalerianate in place of ethylene glycol diacetate.

About 20 hours were required for completely dissolving the sensitizer in the case of using ethylene glycol diacetate, while about 60 hours were required in the case of using ethylene glycol diisovalerianate. Thus, it was found that ethylene glycol diisovalerianate had a poor solubility.

A heat-accelerating test for the preservation stability was carried out in the same way as in Example 1. The results are shown in Table 1.

**Comparative Example 6**

A photoresist composition was prepared in the same way as in Example 1 except for using 3-methoxy-3-methylbutylacetate in place of ethylene glycol diacetate.

About 20 hours were required for completely dissolving the sensitizer in the case of using ethylene glycol diacetate, while about 50 hours were required in the case of using 3-methoxy-3-methylbutylacetate. Thus, it was found that 3-methoxy-3-methylbutylacetate had a poor solubility.

A heat-accelerating test for the preservation stability was carried out in the same way as in Example 1. The results are shown in Table 1.

**Comparative Examples 7 to 9**

Photoresist compositions were prepared in the same way as in Example 1 except for using diethyl carbonate, ethyl acetate and propylene glycol monomethyl ether, respectively, in place of ethylene glycol diacetate.

About 20 hours were required for completely dissolving the sensitizer in the case of using ethylene glycol diacetate, while the sensitizer had not been completely dissolved even after the lapse of 50 hours in any of diethyl carbonate, ethyl acetate and propylene glycol monomethyl ether.

**Comparative Example 10**

A photoresist composition was prepared in the same way as in Example 1 except for using methylethyl ketone in place of ethylene glycol diacetate.

The time required for completely dissolving the sensitizer was shorter than in the case of using ethylene glycol diacetate, but insoluble foreign substances which were visually recognizable generated in the photoresist composition two hours after the complete dissolution.

## Table 1

| | Solvent*) (weight ratio) | Solubility | Coating property | Time elapsed until generation of foreign substances |
|---|---|---|---|---|
| Ex. 1 | EGDAC | Good | Good | No foreign substances produced even after the lapse of 400 hours |
| Ex. 2 | PGDAC | " | " | " |
| Ex. 3 | EGDAC/MEK (90/10) | " | " | " |
| Ex. 4 | PGDAC/EAC (95/5) | " | " | " |
| Ex. 5 | EGDAC/ETL (95/5) | " | " | " |
| Ex. 6 | EGDAC/DON (90/10) | " | " | " |
| Ex. 7 | PGDAC/DEC (90/10) | " | " | " |
| Ex. 8 | EGDAC/PGMME (90/10) | " | " | " |
| Ex. 9 | EGDAC/PGMME (90/10) | " | " | " |
| Comp. 1 | Ethylene glycol ethyl ether acetate | " | " | 168 hours |
| Comp. 2 | Propylene glycol methyl ether acetate | " | " | 125 hours |
| Comp. 3 | Cyclohexanone | " | " | 70 hours |
| Comp. 4 | PGDAC/MEK (50/50) | " | " | 160 hours |
| Comp. 5 | Ethylene glycol diisovalerianate | Bad | — | 90 hours |
| Comp. 6 | 3-methoxy-3-methylbutyl acetate | " | — | 100 hours |
| Comp. 7 | Diethyl carbonate | " | — | — |
| Comp. 8 | Ethyl acetate | " | — | — |
| Comp. 9 | Propylene glycol monomethyl ether | " | — | — |

(Note) *)    EGDAC: Ethylene glycol diacetate
PGDAC: Propylene glycol diacetate
MEK: Methyl ethyl ketone
EAC: Ethyl acetate
ETL: Ethanol
DON: 1,4-dioxane
DEC: Diethyl carbonate
PGMME: Propylene glycol monomethyl ether.

## Claims

1. A positive-type photoresist composition comprising an alkali-soluble resin, a sensitizer having an orthoquinone-diazido group and a solvent, which solvent comprises a diester of glycol, having not more than 10 carbon atoms in total, of formula (I):

$R^1COOCHR^2(CH_2)_nCHR^3OOCR^4$    (I)

wherein $R^1$, $R^2$, $R^3$ and $R^4$, which may be identical or different, each represents a hydrogen atom, a methyl group or an ethyl group, and n is 0, 1 or 2.

2. A composition according to claim 1, wherein said solvent comprises from 60 to 99 wt% of said diester of formula (I) and from 40 to 1 wt% of an organic solvent having a boiling point of from 50 to 140°C.

3. A composition according to claim 1 or 2, wherein said organic solvent having a boiling point of 50 to 140°C is at least one selected from ketones, carboxylates, carbonates, ethers and alcohols.

4. A composition according to claim 3, wherein said organic solvent is acetone, methyl ethyl ketone, diethyl ketone, methyl isobutyl ketone, ethyl acetate, propyl acetate, butyl acetate, dimethyl carbonate, diethyl carbonate, methanol, ethanol, propanol, butanol, methoxy propanol, ethoxy propanol, tetrahydrofuran, dioxane or propylene glycol monomethyl ether.

5. A composition according to any one of the preceding claims wherein said diester of formula (I) is at least one selected from ethylene glycol diacetate, ethylene glycol diformate, ethylene glycol dipropionate, propylene glycol diacetate, propylene glycol dipropionate, butanediol diacetate and butanediol dipropionate.

6. A composition according to any one of the preceding claims, wherein said alkali-soluble resin is selected from a novolak resin, polyhydroxystyrene and a derivative thereof, and a styrene-maleic anhydride copolymer.

7. A composition according to any one of the preceding claims, wherein said sensitizer is an ester or an amido derivative of 1,2-naphthoquinonediazido-5-sulfonic acid, 1,2-naphthoquinonediazido-4-sulfonic acid, or 1,2-benzoquinonediazido-4-sulfonic acid.

8. A composition according to any one of the preceding claims, wherein the weight ratio of said alkali-soluble resin to said sensitizer is from 100 : 5 to 100 : 100.

9. A composition according to any one of the preceding claims, wherein the total concentration of said alkali-soluble resin and said sensitizer in said composition is from 3 to 50 wt%.

10. Use of a composition as defined in any one of the preceding claims as a positive-type photoresist.